# EUROPÄISCHE PATENTANMELDUNG

(11) **EP 0 687 131 A2**
(43) Veröffentlichungstag der Anmeldung: **13.12.1995**
(21) Anmeldenummer: 95108108.2
(22) Anmeldetag: 27.05.1995
(51) Int. Cl.: H05B 1/02, H05B 3/74

(54) **Steuerungsanordnung für ein Elektrowärmegerät**

(30) Priorität: 07.06.1994 DE 4419866
(71) Anmelder: E.G.O. Elektro-Geräte Blanc u. Fischer, D-75038 Oberderdingen (DE)
(72) Erfinder: Götz, Bernhard, D-75059 Zaisenhausen (DE); Schilling, Wilfried, D-76703 Kraichtal (DE); Kleinhans, Andreas, D-75015 Bretten-Gölshausen (DE)
(74) Vertreter: Patentanwälte Ruff, Beier, Schöndorf und Mütschele

(57) **Zusammenfassung**

Eine elektronische Steuerungsanordnung für ein Elektrowärmegerät mit mehreren, getrennt beheizbaren elektrischen Verbrauchern, insbesondere Kochstellen, enthält einen elektronischen Hauptschalter, der eine eigene Stromversorgung aufweist. Dem Hauptschalter nachgeordnet ist eine Steuereinheit, die für jeden elektrischen Verbraucher je eine Steueruntereinheit aufweist. Die Steuereinheit kann für jede Kochstelle einen Temperaturfühler aufweisen, der dann anspricht, wenn die Steuereinheit an dieser Stelle zu warm wird.

## Beschreibung

Die Erfindung betrifft eine Steuerungsanordnung für ein Elektrowärmegerät mit mehreren Verbrauchern, insbesondere eine Glaskeramik-Kochfläche mit mehreren, getrennt schaltbaren Kochstellen. Die Kochstellen werden beispielsweise von Strahlheizkörpern beheizt.

Bei Glaskeramik-Kochflächen ist es bekannt, die einzelnen Kochstellen mit Hilfe von Betätigungselementen ein- und auszuschalten, die durch Berühren einer bestimmten Stelle eines Betätigungsfeldes ausgelöst werden. Durch das Berühren dieser Felder werden elektronische Schaltungen ausgelöst, die dann die Steuerung der elektrischen Leistung übernehmen.

Es ist bereits eine Vorrichtung zur Heizstellenregelung bei einem Kochgerät durch Sensortasten bekannt (DE 691 00 010 T2), bei der die Sensortasten auf einer Leiterplatte unter die Glasfläche geklebt sind. Die Sensortasten werden von den beiden Elektroden eines Kondensators gebildet, die beide in einer Ebene liegen. An die äußere Elektrode wird ein Impulszug angelegt, der kapazitiv auf die andere Elektrode gekoppelt wird. Die innere Elektrode ist mit einem Komparator verbunden. Ändert nun ein Benutzer mit seinem Finger die Kapazität des Kondensators, so stellt dies der Komparator fest und kann einen Schaltungsvorgang auslösen.

Die Elektrodenflächen sind umgeben von Kupferbahnen der elektronischen Schaltung, die bewirken, daß es bei jeder Betätigungsfläche zu unterschiedlichen kapazitiven Einkopplungen kommt, was eine Auswertung des kapazitiven Nutzsignals erschwert. In der Praxis muß jede kapazitive Sensorfläche auf ihre Umgebung durch eine speziell dimensionierte Referenzspannung angepaßt werden. Dies erfordert bei der Anordnung vieler Sensorflächen einen großen Schaltungsaufwand.

Bislang sind auch elektronische Berührschaltungen als Einzelelemente bekannt, die nebeneinander angeordnet werden können.

Der Erfindung liegt die Aufgabe zugrunde, eine Steuerungsanordnung der eingangs genannten Art zu schaffen, die einen vereinfachten Aufbau und verbesserte Steuerungsmöglichkeiten erlaubt.

Zur Lösung dieser Aufgabe schlägt die Erfindung eine Steuerungsanordnung mit den Merkmalen des Anspruchs 1 vor. Weiterbildungen der Erfindung sind Gegenstand der Unteransprüche.

Insbesondere kann vorgesehen sein, daß die Sensorfläche jedes Betätigungselements von je einer Abschirmleitung umgeben ist, wobei die Abschirmleitungen aller Sensorflächen an ein Abschirmpotential gelegt sind, beispielsweise über einzelne aber gleich große Widerstände an Masse. Dadurch sind die Einflüsse der Umgebung auf die einzelnen Sensorflächen weitestgehend gleich, so daß zur Signalauswertung für alle Sensorflächen eine identische Bezugsspannung benutzt werden kann.

Die Erfindung schlägt vor, die Steuereinheit in einem an die Unterseite der Glasplatte angeklebten Gehäuse unterzubringen. Das Ankleben des Gehäuses vorzugsweise längs einer geschlossenen Fläche hat den Vorteil, daß keine Feuchtigkeit an die Unterseite der Glasplatte in dem Gehäuse eindringen kann, was für das korrekte Arbeiten der Sensorelemente schädlich wäre. Es ist dadurch nicht erforderlich, die die Sensoreinheiten aufweisende Leiterplatte an der Glasplatte anzukleben.

Erfindungsgemäß kann in Weiterbildung vorgesehen sein, daß die Sensorflächen und die Abschirmleitungen auf einer der Unterseite der Glasplatte zugewandten Seite einer Sensorleiterplatte angeordnet sind, die unter Federspannung gegen die Glasplatte angedrückt wird.

Die Erfindung schlägt in Weiterbildung vor, daß die von den Betätigungselementen angesteuerte Steuerelektronik für die Verbraucher auf mindestens einer Leiterplatte angeordnet sind, der die Sensor-Leiterplatte über elektrisch leitende Federelemente verbunden ist. Diese Federelemente können sowohl das Andrücken der Sensor-Leiterplatte an die Glasfläche als auch die Stromverbindung übernehmen. Besonders günstig ist es, wenn die Federn in SMD-Technik ausgebildet sind, da sie sich dann wie übliche SMD-Bauteile befestigen lassen. Die Federn können zu diesem Zweck ein ebenes flächiges Ende aufweisen, das in Form und Größe einer SMD-Kontaktstelle entspricht. Beim Verlöten richten sich dann aufgrund der Oberflächenspannung des flüssigen Lötzinns diese Anschlußstellen aus.

Erfindungsgemäß kann vorgesehen sein, daß die die Steuerelektronik aufnehmende Leiterplatte aus zwei mit Abstand voneinander angeordneten Leiterplatten aufgebaut ist, wobei die Anschlußteile für die Sensorflächen und die Anzeigeelemente auf der der Glasplatte zugewandten Seite der einen und die Anschlüsse für die Verbraucher und den Netzanschluß auf der anderen Seite der anderen Leiterplatte angeordnet sind. Auf diese Weise läßt sich eine schnelle Montage und ein schneller Anschluß der Steuereinheit durchführen.

Zur Herstellung einer derartigen zweiteiligen Leiterplatte schlägt die Erfindung vor, die Leiterplatte zunächst als ein Element aufzubauen und die Bestückung von einer Seite vorzunehmen. Anschließend kann die Leiterplatte längs einer Längslinie getrennt und ein Teil um diese Trennlinie herum um 180° umgeklappt werden. Die beiden Teile lassen sich dann in dieser Weise mit Abstandshaltern o. dgl. aneinander befestigen.

Erfindungsgemäß kann vorgesehen sein, daß für jeden elektrischen Verbraucher ein Anzeigeelement vorhanden ist, das beispielsweise eine eingestellte Schaltstufe anzeigt. Beispielsweise können diese Anzeigen auf der der Glasplatte zugewandten Leiterplatte der Steuerelektronik angeordnet sein, wobei die Sensor-Leiterplatte dann eine Öffnung aufweist, damit das Anzeigeelement sichtbar ist. Die Öffnungen können zum Parallaxenausgleich seitlich versetzt sein. Als Anzeigeelemente eignen sich insbesondere 7-Segmentanzeigen, die zur Anzeige von Zahlen, Buchstaben und anderen Symbolen angesteuert werden können.

Die Erfindung schlägt vor, der Steuereinheit einen Hauptschalter zuzuordnen, der der Steuereinheit derart vorgeschaltet sein kann, daß er diese ein- und ausschaltet. Der Hauptschalter kann entweder als getrennte Einheit vorgesehen werden, beispielsweise auch an einer anderen Stelle des Kochfelds angeordnet werden, er kann aber auch mit der Steuereinheit als bauliche Einheit zusammengefaßt werden.

Die Zusammenfassung der einzelnen bislang als Einzelelemente bekannten Steueruntereinheiten zu einer zusammengefaßten Einheit ermöglicht eine Vereinfachung des Aufbaus. Die Trennung in eine Steuereinheit und einen Hauptschalter macht eine sinnvolle Zusammenfassung und Aufteilung elektronischer Funktionen möglich. Wird die Steuereinheit mit Hilfe des Hauptschalters abgeschaltet, so kann beispielsweise beim Reinigen der Herdfläche keine Auslösung von Vorgängen erfolgen. Es ist möglich, den Hauptschalter an einer anderen Stelle anzuordnen als die eigentliche Steuereinheit.

Erfindungsgemäß kann in Weiterbildung der Erfindung vorgesehen sein, daß der Hauptschalter beim Einschalten die Steuerspannung der ihm nachgeordneten Steuereinheit einschaltet. Vorher ist die gesamte Steuereinheit also außer Betrieb. Dies dient beispielsweise einer Stromeinsparung, da während der gesamten Zeit, in der das Elektrowärmegerät nicht verwendet wird, in der Steuereinheit kein Strom zu fließen braucht.

Erfindungsgemäß kann der Hauptschalter bzw. sein Betätigungselement derart ausgebildet sein, daß dieser nur dann eingeschaltet wird, wenn das Betätigungselement nur von einem kleinen Gegenstand an einer bestimmten Stelle betätigt wird. Dies kann beispielsweise dadurch geschehen, daß das Betätigungselement des Hauptschalters von einer relativ kleinen, etwa einer Fingerkuppe entsprechenden mittleren Elektrode, einer diese umgebenden zweiten und einer diese nochmals umgebenden dritten Elektrode gebildet wird. Dadurch werden zwei Kondensatoren mit einer gemeinsamen Elektrode gebildet, die derart geschaltet sein können, daß nur eine Veränderung der Kapazität zwischen der inneren und der mittleren Elektrode ohne Veränderung der Kapazität zwischen der mittleren und äußeren Elektrode zu einem Einschalten führt. Damit soll erreicht werden, daß beim Berühren mit einem großflächigen Gegenstand kein Einschalten erfolgen kann, also beispielsweise beim Abwischen des Herds mit einem Tuch. Nur dann, wenn ein Benutzer seinen Finger auf den Mittelpunkt des Betätigungselements legt, erfolgt ein Einschalten. Dies kann gleichzeitig einen Schutz davor bilden, daß überlaufendes Kochgut zu einer Einschaltung führt.

Die Erfindung schlägt vor, daß die Vorrichtung eine Restwärmeanzeige aufweisen kann, die aufgrund der eingestellten Steuerparameter eine Restwärme errechnet und eine Anzeige so lange ansteuert, wie die Temperatur einen bestimmten Wert überschreitet.

Erfindungsgemäß kann die Steuerungsanordnung eine Standby-Schaltung mit einer eigenen Stromversorgung aufweisen. Im inaktiven Betrieb erhält dann die Steuereinheit keine Leistungsversorgung, so daß sie auch keinen Stromverbrauch aufweist. Die Standby-Schaltung versorgt nur den Hauptschalter mit Energie, so daß durch Betätigen des Hauptschalters die Steuereinheit eingeschaltet werden kann.

Erfindungsgemäß kann in Weiterbildung vorgesehen sein, daß die Steuerspannung der Steuereinheit nach dem Ausschalten des letzten Verbrauchers noch so lange erhalten bleibt, wie eine Restwärmeanzeige anzeigt, daß mindestens einer der elektrischen Verbraucher noch eine Temperatur aufweist, die für den Benutzer des Elektrowärmegeräts beim Berühren schmerzhaft sein kann. Erst dann, wenn diese Restwärmeanzeige bei Unterschreiten einer bestimmten Temperatur erlischt, wird die Steuereinheit stromlos und bleibt es so lange, bis sie durch den Hauptschalter wieder eingeschaltet wird.

Erfindungsgemäß kann vorgesehen sein, daß der Hauptschalter nur ein einziges Betätigungselement aufweist, mit dessen Hilfe die Spannungsversorgung zu der Steuereinheit eingeschaltet wird. Wie bereits erwähnt, erfolgt das Ausschalten des Hauptschalters nach Abschalten des letzten Verbrauchers und dem verzögerten Abschalten der Restwärmeanzeige von allein.

Die Standby-Schaltung kann derart ausgebildet sein, daß sie im inaktiven Zustand auch die Verbraucher allpolig abschaltet. Die Abschaltung der Verbraucher erfolgt zwar schon durch die Steuereinheit, jedoch kann eine allpolige Trennung der Verbraucher durch die Standby-Schaltung weitere Vorteile bewirken.

Die Erfindung schlägt in Weiterbildung vor, daß die Steuereinheit, sobald sie mit Spannung versorgt wird, dem Hauptschalter ein kontinuierliches Signal zurückmeldet. Dieses Rückmeldungssignal kann beispielsweise als Taktsignal von einem Mikroprozessor der Steuereinheit erzeugt werden. Tritt in der Steuereinheit eine Störung auf, so führt dies dazu, daß das Rückmeldesignal ausfällt oder sich ändert. Dieser Vorgang kann dazu verwendet werden, die Spannungsversorgung zu der Steuereinheit abzuschalten oder zu unterbrechen.

In Weiterbildung kann vorgesehen sein, daß die Steuereinheit mindestens einen Temperaturfühler aufweist, vorzugsweise für jeden in ihrer Nähe angeordneten elektrischen Verbraucher einen eigenen Temperaturfühler. Dieser Temperaturfühler dient zum einen dem Schutz der Elektronik vor einer Überhitzung durch Fehlbedienung und zum anderen auch dem Schutz der Person, die den Herd benutzt. Erfindungsgemäß kann die Steuereinheit derart ausgebildet sein, daß sie bei Ansprechen eines Temperaturfühlers den diesem nächstgelegenen elektrischen Verbraucher ausschaltet. Das Ansprechen des Temperaturfühlers kann beispielsweise dadurch verursacht sein, daß ein auf einem elektrischen Verbraucher stehender Topf so verschoben wird, daß er auf der Berührfläche für die zugeordnete Steuereinheit steht. In diesem Fall besteht natürlich die Gefahr der Überhitzung der Elektronik. Andererseits wird durch den Topf dann eine Stelle erhitzt, von der der Benutzer des Herdes nicht annimmt, daß sie heiß sein kann.

Stellt die Steuereinheit fest, daß nach Abschalten des einen Verbrauchers die Temperatur nicht abnimmt, so kann sie nach einer gewissen Zeit alle Verbraucher abschalten.

Erfindungsgemäß kann vorgesehen sein, daß die Steuereinheit für jeden Verbraucher ein Betätigungselement zum Einschalten sowie mindestens ein Betätigungselement zum Einstellen einer Schaltstufe, einer Leistung o. dgl. aufweist. Nach Einschalten des Kochfelds durch den Hauptschalter muß also eine spezielle Kochstelle nochmals durch ein Betätigungselement eingeschaltet werden, so daß erst dann die entsprechende Schaltstufe durch einen dritten Vorgang eingestellt wird. Hierzu kann beispielsweise vorgesehen sein, daß jede Schaltstufe ein eigenes Betätigungselement aufweist, die beispielsweise in Form einer geraden Linie oder in Kreisform angeordnet sind. Bei der Kreisform würde die Art der Bedienung eines herkömmlichen Drehschalters optisch simuliert.

Ebenfalls möglich ist es, daß ein Betätigungselement zum Erhöhen der Schaltstufe und ein Betätigungselement zum Erniedrigen der Schaltstufe vorgesehen sind. Dies ist insbesondere dann von Vorteil, wenn die Schaltstufe durch eine Ziffernanzeige angezeigt wird.

Bei einer Anordnung eines Betätigungselements für jede Schaltstufe kann eine Anzeige beispielsweise neben dem jeweiligen Betätigungselement erfolgen.

Die Erfindung schlägt vor, der Steuereinheit oder dem Hauptschalter ein eine Verriegelungsfunktion übernehmendes Betätigungselement zuzuordnen, also eine Art Verriegelungstaste. Diese bewirkt, wenn sie bei ausgeschaltetem Kochfeld betätigt wird, eine Verriegelung aller Betätigunselemente, so daß dann keine Einschaltung erfolgen kann. Gegebenenfalls kann vorgesehen sein, daß noch weitere Sensorflächenberührungen durchgeführt werden müssen, um die Verriegelung vorzunehmen und/oder wieder aufzuheben.

Die Erfindung schlägt vor, daß die Steuerungsanordnung eine Topferkennung aufweisen kann, vorzugsweise für jede Kochstelle. Die an sich bekannte Topferkennung kann sowohl dazu verwendet werden, dem Benutzer eine Anzeige zu liefern, daß kein Topf vorhanden ist oder der Topf nicht richtig steht oder auch dazu, ein Einschalten einer Kochstelle zu unterbinden.

Erfindungsgemäß kann in Weiterbildung die Steuereinheit derart ausgebildet sein, daß sie bei einem zu langen Betätigen einer Sensorfläche alle Verbraucher abschaltet. Dies wird dann als Fehlersignal interpretiert.

Ebenfalls kann vorgesehen sein, daß bei gleichzeitiger Betätigung mehrerer Betätigungselemente keine Änderung des Zustand ausgeführt wird.

In nochmaliger Weiterbildung kann vorgesehen sein, daß alle sicherheitsrelevanten Systemzustände innerhalb der Steuereinheit mehrfach gespeichert und regelmäßig auf Gleichheit überprüft werden. Hierdurch können Störungen in der Funktion erkannt und zum Abschalten der Verbraucher verwendet werden.

Weitere Merkmale, Einzelheiten und Vorzüge ergeben sich aus den Patentansprüchen, deren Wortlaut durch Bezugnahme zum Inhalt der Beschreibung gemacht wird, der folgenden Beschreibung einer bevorzugten Ausführungsform der Erfindung sowie anhand der Zeichnung. Hierbei zeigen:
- Fig. 1: vereinfacht ein Blockdiagramm der Steuerungsanordnung nach der Erfindung;
- Fig. 2: schematisch eine ein Sensorelement umgebende Abschirmleitung;
- Fig. 3: schematisch die Aufsicht auf eine Glaskeramik-Kochfläche mit vier Kochflächen und einer Steuerungsanordnung nach der Erfindung;
- Fig. 4: eine perspektivische Teilaufsicht auf die Steuereinheit;
- Fig. 5: eine perspektivische Teilansicht der Steuereinheit von unten;
- Fig. 6: einen Schnitt durch ein Kochfeld mit einer in einem Gehäuse unter der Glasplatte angeordneten Steuereinheit;
- Fig. 7: das schematische Schaltbild eines Betätigungsvorgangs;
- Fig. 8: zwei Anzeigezustände eines Topferkennungssystems mit Hilfe einer 7-Segmentanzeige.

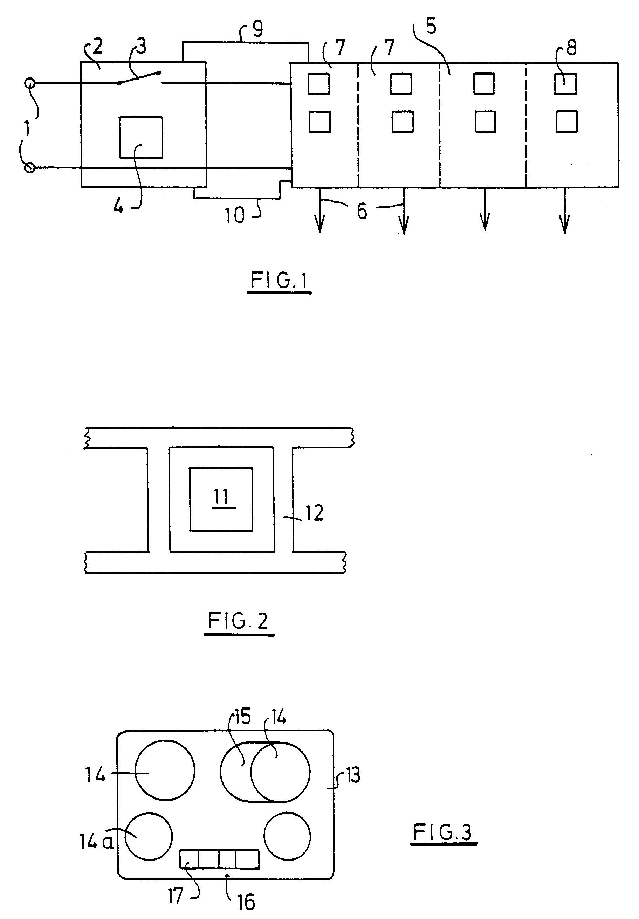

Die in Fig. 1 schematisch dargestellte Steuerungsanordnung zeigt links zwei Anschlüsse für eine Spannungsversorgung. Die Steuerungsanordnung enthält einen Hauptschalter 2, der durch das Schaltsymbol 3 für einen Schalter gekennzeichnet ist. Dieser Schalter ist als elektronisches Schaltelement ausgebildet. Zu seiner Betätigung enthält der Hauptschalter 2 ein Betätigungselement 4, das beispielsweise ein Berührschalter ist und durch ein Berührfeld dargestellt wird.

Dem Hauptschalter nachgeordnet ist eine Steuereinheit 5, die zum Ansteuern der einzelnen elektrischen Verbraucher dient. Diese Ansteuerung wird durch die mit den Pfeilen versehenen Leitungen 6 dargestellt. Die Steuereinheit 5 enthält intern vier Steueruntereinheiten 7, die jeweils ein oder mehrere Betätigungselemente 8 für die zugeordneten elektrischen Verbraucher aufweisen. Beispielsweise kann eine Taste zum Erhöhen und eine Taste zum Erniedrigen der Leistung vorgesehen sein. Diese vier identisch aufgebauten und ausgebildeten Steueruntereinheiten 7 sind in der Steuereinheit 5 zusammengefaßt.

Zwischen dem Hauptschalter 2 und der Steuereinheit 5 ist eine weitere Steuerleitung 9 vorgesehen, mit der der Steuereinheit 5 mitgeteilt wird, daß der Hauptschalter 2 eingeschaltet wurde.

Die Steuereinheit 5 meldet ihren Betrieb über eine Rückmeldeleitung 10 an den Hauptschalter 2 zurück. Beispielsweise wird auf dieser Leitung ein getaktetes Signal zurückgegeben, dessen Ausfall ein Zeichen dafür ist, daß die Steuereinheit 5 nicht korrekt funktioniert. In diesem Fall schaltet der Hauptschalter 2 die Leistungsversorgung zu allen elektrischen Verbrauchern ab. In der Steuereinheit 5 wird dann nur noch der Teil mit Spannung versorgt, der die Restwärmeanzeige betreibt.

Fig. 2 zeigt die schematische Anordnung eines Sensorelements 11, das jeweils einem Betätigungselement 8 der vier Steueruntereinheiten 7 zugeordnet ist. Das Sensorelement ist von einem Abschirmleiter 12 umgeben, der sich in beide Richtungen zu den Sensorelementen der anderen Betätigungselemente 8 fortsetzt und gemeinsam über einen Widerstand an Masse gelegt ist. Dadurch erfolgt eine Abschirmung jedes Sensorelementes 11 und damit jedes Betätigungselementes 8 von den anderen Betätigungselementen.

Fig. 3 zeigt eine Aufsicht auf eine Glaskeramik-Kochfläche 13 mit vier Kochstellen 14, die beispielsweise Strahlheizkörper aufweisen. Eine Kochstelle 14 enthält ein zuschaltbares Feld 15.

An der Vorderseite ist das Berührfeld 16 der Steuereinheit 5 in der Glaskeramik-Kochfläche angeordnet. Die Steuereinheit 5 liegt unmittelbar mit geringem Abstand unter der Glaskeramik-Kochfläche. Für jede Kochstelle 14 enthält das Betätigungsfeld 16 je ein Unterfeld 17. Die Steuereinheit 5, die der Anordnung der Fig. 3 zugeordnet ist, enthält nun beispielsweise zwei Temperaturfühler, von denen der eine im Bereich des linken Endes und der zweite im Bereich des rechten Endes angeordnet ist. Zeigt nun beispielsweise der links angeordnete Temperaturfühler eine zu hohe Temperatur an, so kann dies ein Zeichen dafür sein, daß auf der unmittelbar benachbarten Kochstelle 14a ein heißer Topf seitlich verschoben wurde, so daß er über dem zugeordneten Bedienfeld 17 der Steuereinheit 5 angeordnet ist. In diesem Fall schaltet die Steuereinheit 5 die Leistungsversorgung zu dieser Kochstelle 14a ab. Erfolgt nach Abschalten der Leistungsversorgung keine Verringerung der von dem zugeordneten Temperaturfühler angezeigten Temperatur, so erfolgt nach einer gewissen Zeit eine Abschaltung aller Kochstellen 14.

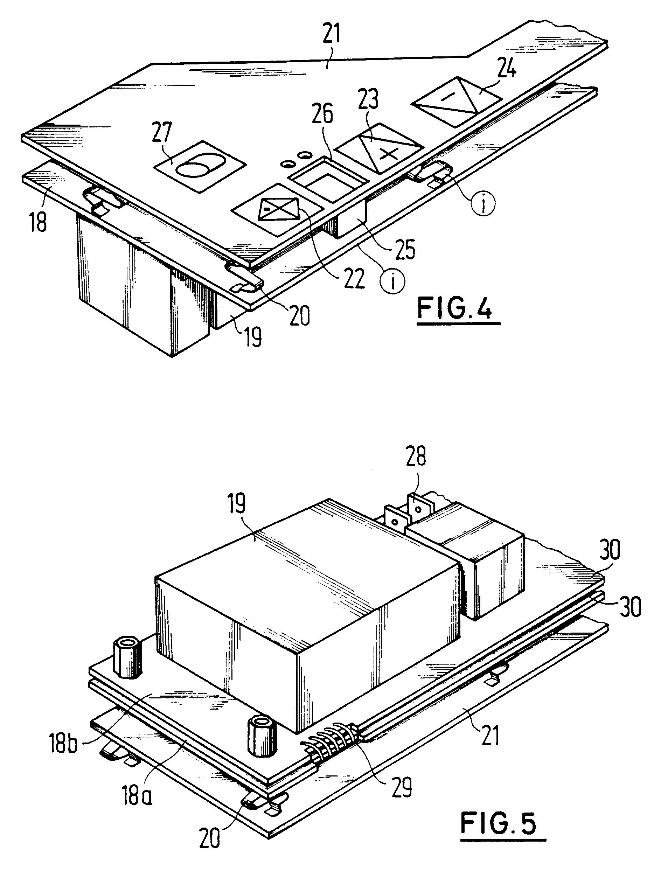

Fig. 4 zeigt perspektivisch einen Teil der Steuereinheit 5. Diese enthält eine Leiterplatte 18, auf der einzelne Bauelemente der Steuerelektronik untergebracht sind. Hierzu gehört beispielsweise ein Netztransformator 19. Auf der Oberseite der Leiterplatte 18, d. h. der der Unterseite der Glaskeramikplatte zugewandten Seite, sind auf der Leiterplatte 18 mehrere zickzackförmig gebogene Federn 20 befestigt, beispielsweise angelötet. Diese Federn sind an ihrem anderen Ende, d. h. in Fig. 4 dem oberen Ende, mit Kontaktflächen einer weiteren Leiterplatte 21 verbunden. Diese Leiterplatte 21 enthält für jeden elektrischen Verbraucher eine erste Sensorfläche 22, die zum Einschalten des entsprechenden Verbrauchers dient. Darüber hinaus ist eine zweite Sensorfläche 23 zum Erhöhen der Schaltstufe und eine dritte Sensorfläche 24 zum Erniedrigen der Schaltstufe vorgesehen.

Die Stromversorgung zwischen der Steuerelektronik, die auf der Leiterplatte 18 angeordnet ist, und den leitenden Sensorflächen 22 bis 24 erfolgt über die Federn 20.

Die in Fig. 4 zu sehende Leiterplatte 18 für die Steuerelektronik enthält auf ihrer Oberseite darüber hinaus eine 7-Segmentanzeige 25. Die Sensor-Leiterplatte 21 enthält an dieser Stelle eine Durchbrechung 26, die die gleiche Rechteckform aufweist wie die Anzeige 25, jedoch zum Parallaxenausgleich etwas versetzt angeordnet ist.

Darüber hinaus kann die Sensor-Leiterplatte 21 Dekorelemente aufweisen, beispielsweise das Symbol 27 für die Hinzuschaltung einer Zusatzheizfläche.

Fig. 5 zeigt die Anordnung der Fig. 4 perspektivisch von unten, wobei die Leiterplatte 18 für die Steuerelektronik aus zwei Leiterplattenteilen 18a und 18b aufgebaut ist, die mit gewissem Abstand voneinander parallel zueinander angeordnet sind. Auf der in Fig. 5 oberen Seite des Leiterplattenteils 18b, d. h. in Funktion der unteren Platte, sind Flachsteckzungen 28 zum Anschluß der Netzzuleitung angeordnet. Wird die Steuereinheit der Fig. 5, enthaltend die beiden Leiterplattenteile 18a und 18b und die Sensorleiterplatte 21, in der dargestellten und beschriebenen Weise an die Unterseite einer Glaskeramikfläche angebracht, so sind die Flachsteckzungen 28 nach unten gerichtet, so daß man die Verbindung mit einem Netzkabel hier sehr einfach und leicht durchführen kann.

Zwischen den beiden Leiterplattenteilen 18a, 18b sind mehrere Verbindungsdrähte 29 angeordnet, die nicht nur eine elektrische Verbindung zwischen den beiden Teilen herstellen, sondern auch eine mechanische Verbindung. Die beiden Leiterplattenteile 18a, 18b werden zunächst als eine Leiterplatte hergestellt und von einer Seite bestückt. Nach Fertigstellung der Bestückung werden sie längs einer die Längskanten 30 bildenen Linie aufgetrennt und um diese Linie zusammengeklappt, so daß jetzt die Bestückung jeweils an den Außenseiten liegt.

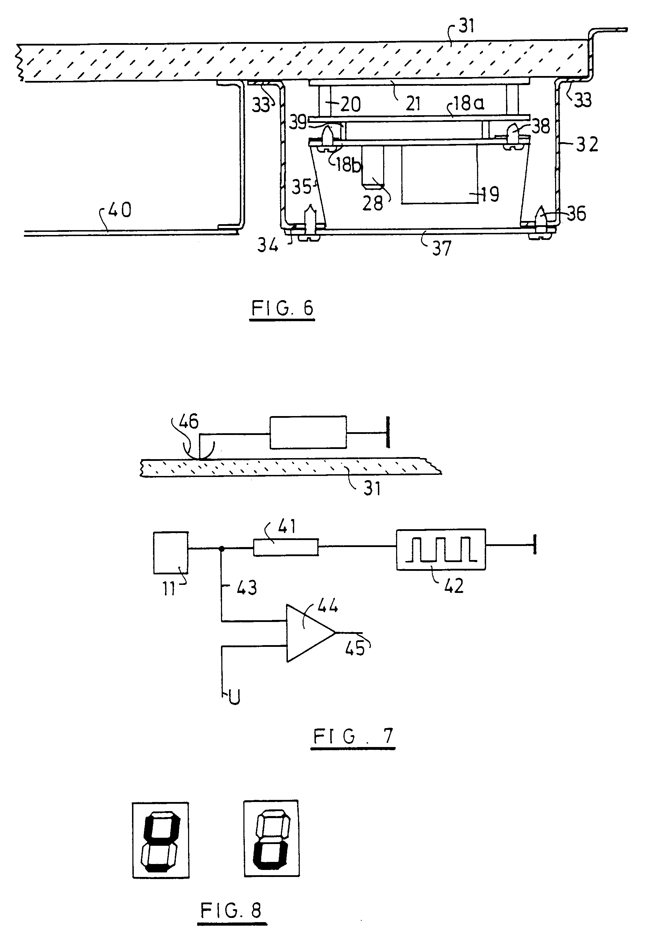

Fig. 6 zeigt nun die Anbringung der Steuereinheit 5 an der Unterseite einer Glasplatte 31. Zur Unterbringung der Steuereinheit 5 ist ein aus Blech hergestelltes Gehäuse 32 vorgesehen, das längs seines oberen Randes einen in einer Ebene liegenden Flansch 33 aufweist. Auf der Fläche dieses Flanschs 33, der rechts als Schulter ausgebildet ist, ist mit Hilfe eines Silikonklebers o. dgl. das Gehäuse 32 an die Unterseite der Glasplatte 31 angeklebt. Die Klebestelle bildet dabei einen geschlossenen ebenen Rand, so daß das Gehäuse 32 an der Verbindungsstelle mit der Glaskeramikplatte 31 gegen Eindringen von Feuchtigkeit an dieser Stelle gesichert ist.

An seiner Unterseite enthält das Gehäuse 32 eine Öffnung, die von einem ebenen Rand 34 umgeben ist. An dem Rand 34 wird mit Hilfe von Bügeln 35 die Steuereinheit 5 befestigt, wobei die Bügel 35 etwa z-förmig ausgebildet sind und ihre unteren Enden mit Hilfe von Schrauben 36 an dem Randflansch 34 festgeschraubt werden. Mit den Schrauben 36 kann gleichzeitig auch ein Abschlußdeckel 37 angeschraubt werden.

Die oberen Enden der Bügel 35 sind um die Ränder der Leiterplatte 18b herumgebogen und dort mit Hilfe von weiteren Schrauben 38 festgeschraubt. Die Ränder der Leiterplatte 18b können Kerben aufweisen, in die die Bügel 35 zu liegen kommen.

Oberhalb der Leiterplatte 18b ist der Leiterplattenteil 18a angeordnet, der mit Hilfe von Abstandshaltern 39 auf Abstand gehalten wird. Die Federn 20 drücken die Sensor-Leiterplatte 21 gegen die Unterseite der Glasplatte 31.

Nach Anbringen des Deckels 37 ist das Gehäuse 32 geschlossen und die gesamte Steuereinheit 5 mechanisch und gegen das Eindringen von Feuchtigkeit an der Unterseite der Glasplatte geschützt untergebracht.

Mit einem gewissen Abstand von dem Gehäuse 32 ist ein weiteres Gehäuse 40 für die Unterbringung der Heizkörper des Glaskeramikkochfeldes angeordnet.

Fig. 7 zeigt schematisch das Schaltbild zur Auslösung eines Betätigungsvorgangs. An der Unterseite der Glasplatte 31 ist das Sensorelement 11 angeordnet. Es wird von einer metallisch leitenden Beschichtung auf der Sensor-Leiterplatte 21 gebildet. Das Sensorelement 11 kann von der in Fig. 2 dargestellten und hier aus Gründen der Vereinfachung weggelassenen Abschirmleitung 12 umgeben sein. Das Sensorelement 11 ist über eine Impedanz 41 mit einem Impulsgenerator 42 verbunden, der Rechteckimpulse abgibt. Das Sensorelement 11 ist über eine weitere Leitung 43 mit dem einen Eingang eines Komparators 44 verbunden. Der andere Eingang des Komparators 44 liegt an einer definierten Spannung U.

Am Ausgang 45 des Komparators 44 liegt eine Signalspannung einer bestimmten Form. Nähert sich nun ein Benutzer mit seinem bei 46 angedeuteten Finger dem Sensorelement 11, so ändert sich aufgrund der veränderten Verhältnisse die Form des Signals am Ausgang des Komparators 44. Da der Komparator 44 das Signal an seinem Eingang 43 mit einer konstanten festen Bezugsspannung vergleicht, verändert sich bei Annäherung an das Sensorelement 11 die Impulsbreite der Impulszüge am Ausgang 45 des Komparators 44. Bei Berühren der Glaskeramikplatte 31 oberhalb des Sensorelements 11 werden die Impulse am Ausgang des Komparators schmäler. Diese Änderung des Signals wird dann zur Auslösung von Steuerungsvorgängen verwendet.

Die Steuereinheit 5 kann eine Topferkennungsschaltung enthalten. Fig. 8 zeigt eine 7-Segmentanzeige, die links die obere Hälfte der 7-Segmentanzeige u-förmig und die untere Hälfte mit einem unteren Balken ansteuert. Die rechte Hälfte der Fig. 8 zeigt das U im unteren Teil der 7-Segmentanzeige, was eine korrekt aufgesetzten Topf darstellen soll. Insbesondere bei einem Hin- und Herschalten zwischen den beiden Symbolen wird dem Benutzer recht deutlich das nicht korrekte Aufsitzen des Kochtopfs auf der Kochstelle signalisiert.

Die in den Figuren dargestellte und beschriebene Vorrichtung arbeitet wie folgt. Eingeschaltet wird das Kochfeld durch Betätigen des Berührungsfelds 4 des Hauptschalters 2. Dieses Berührungsfeld 4 muß an einer relativ eng definierten Stelle berührt werden, ohne daß die Umgebung berührt wird. Es soll vermieden werden, daß beim Abwischen der Oberfläche ein Einschalten unbeabsichtigt erfolgt. Der Hauptschalter 2 schaltet die nachgeordnete Steuereinheit 5 ein. In dieser Steuereinheit 5 sind zunächst noch alle elektrischen Verbraucher ausgeschaltet. Zum Aktivieren eines elektrischen Verbrauchers muß zunächst die zugeordnete Steueruntereinheit 7 durch Betätigen des Sensorfelds 22, siehe Fig. 4, aktiv gemacht werden, worauf anschließend dann der elektrische Verbraucher durch Betätigen des Sensorfelds 23 auf eine bestimmte Schaltstufe eingeschaltet wird.

Die Steuereinheit 5 meldet über die Rückmeldeleitung 10 dem Hauptschalter 2, daß sie korrekt arbeitet. Zu diesem Zweck gibt sie auf dieser Leitung einen ständigen Impulszug ab. Sobald dieser Impulszug gestört ist, also entweder ganz ausfällt oder in seiner Frequenz geändert wird, erkennt die Steuerung des Hauptschalters 2, daß ein Fehler vorliegt, und schaltet die Steuereinheit 5 ab. Ebenfalls möglich ist eine allpolige Trennung der elektrischen Verbraucher vom Netz.

Werden alle elektrischen Verbraucher des Kochfelds abgeschaltet, so bleibt die Steuereinheit 5 noch so lange in Betrieb, bis eine Restwärmeanzeige nicht mehr arbeitet. Dann wird die Stromversorgung der Steuereinheit 5 abgeschaltet, und nur der Hauptschalter 2 arbeitet im Standby-Betrieb.

## Patentansprüche

1. Steuerungsanordnung für ein Elektrowärmegerät mit mehreren Verbrauchern, insbesondere eine Kochfläche mit mehreren getrennt beheizbaren Kochstellen (14), mit
1.1 einer Steuereinheit (5) für die elektrischen Verbraucher, die
1.2 für jeden zu steuernden elektrischen Verbraucher eine Steueruntereinheit (7) mit mindestens einem Betätigungselement (8) aufweist, das
1.3 eine unterhalb der Glasplatte (31) des Kochfelds angeordnete elektrisch leitende Sensorfläche (11, 22, 23, 24) aufweist, die
1.4 mit einer von einem Impulsgenerator (42) über eine Impedanz (41) zu einem Komparator (44) führenden Leitung (43) verbunden ist, der
1.5 bei Annäherung an die Sensorfläche (11) eine Ausgangssignaländerung bewirkt.

2. Steuerungsanordnung nach Anspruch 1, bei der die Sensorfläche (11) jedes Betätigungselements (8) von je einer Abschirmleitung (12) umgeben ist, die an ein Abschirmpotential gelegt sind, beispielsweise an Masse, wobei insbesondere die Sensorfläche (11, 22, 23, 24) und die Abschirmleitung (12) auf einer der Unterseite der Glasplatte (31) zugewandten Sensor-Leiterplatte (21) angeordnet sind, vorzugsweise auf deren der Glasplatte (31) zugewandten Seite, wobei die Sensor-Leiterplatte (21) gegen die Glasplatte (31) unter Federspannung angedrückt wird.

3. Steuerungsanordnung nach Anspruch 1 oder 2, bei der die Steuereinheit (5) in einem an die Unterseite der Glasplatte (31) angeklebten Gehäuse (32) angeordnet ist.

4. Steuerungsanordnung nach einem der vorhergehenden Ansprüche, bei der die von den Betätigungselementen (8) angesteuerte Steuerelektronik für die elektrischen Verbraucher auf mindestens einer Leiterplatte (18) angeordnet ist, mit der die Sensor-Leiterplatte (21) über elektrisch leitende Federn (20) verbunden ist, die insbesondere in SMD-Technik ausgebildet und befestigt sind.

5. Steuerungsanordnung nach Anspruch 4, bei der die Leiterplatte (18) für die Steuerelektronik aus zwei mit Abstand voneinander angeordneten Leiterplattenteilen (18a, 18b) aufgebaut ist, wobei die Anschlüsse für die Sensorflächen (11, 22, 23, 24) und die Anzeige auf der zu der Glasplatte (31) gerichteten Seite des einen Leiterplattenteils (18a) und die Anschlüsse für die elektrischen Verbraucher und das Netz auf der anderen Seite des anderen Leiterplattenteils (18b) angeordnet sind und bei der vorzugsweise die Leiterplatte (18) für die Steuerelektronik, insbesondere die der Glasplatte (31) zugewandte Teilplatte (18a), für jeden Verbraucher ein Anzeigeelement (25) aufweist, das durch eine Durchbrechung (26) in der Sensor-Leiterplatte (21) sichtbar ist.

6. Steuerungsanordnung nach einem der vorhergehenden Ansprüche, bei der die Steuereinheit (5) mindestens einen Temperaturfühler vorzugsweise für jeden in ihrer Nähe angeordneten Verbraucher (14) je einen eigenen Temperaturfühler aufweist und insbesondere derart ausgebildet ist, daß sie bei Ansprechen eines Temperaturfühlers den diesem nächstgelegenen elektrischen Verbraucher (14a) ausschaltet und insbesondere nach dem durch den Temperaturfühler ausgelösten Abschalten eines Verbrauchers (14a) bei nicht abnehmender Temperatur alle Verbraucher abschaltet.

7. Steuerungsanordnung nach einem der vorhergehenden Ansprüche, mit einem Hauptschalter (2), der mit der Steuereinheit (5) über eine Steuerleitung (9) und eine Rückmeldeleitung (10) verbunden ist, auf der die Steuereinheit (5) ein kontinuierliches Impulssignal zurücksendet, wobei insbesondere der Hauptschalter (2) ein einziges Betätigungselement (4) aufweist, das bei Betätigung den Hauptschalter (2) in den jeweils anderen Zustand schaltet und vorzugsweise derart ausgebildet ist, daß dieser nur dann eingeschaltet werden kann, wenn das Betätigungselement (4) nur von einem kleinen Gegenstand und/oder an einer eng begrenzten Stelle betätigt wird.

8. Steuerungsanordnung nach einem der vorhergehenden Ansprüche, mit einer Restwärmeanzeige, die aufgrund der Steuerparameter eine vorhandene Restwärme errechnet und eine Anzeige so lange ansteuert, wie die Temperatur einen bestimmten Wert überschreitet.

9. Steuerungsanordnung nach einem der vorhergehenden Ansprüche, mit einer Standby-Schaltung mit eigener Stromversorgung, die insbesondere derart angeordnet ist, daß sie die Stromversorgung zur Steuereinheit (5) erst dann abschaltet, wenn die Restwärmeanzeige unterhalb des bestimmten Werts liegt, und/oder derart ausgebildet ist, daß sie die Verbraucher allpolig abschaltet.

10. Steuerungsanordnung nach einem der vorhergehenden Ansprüche, bei der die Steueruntereinheit (7) für jeden Verbraucher ein Betätigungselement (8) zum Einschalten sowie mindestens ein Betätigungselement zum Einstellen einer Schaltstufe, vorzugsweise für jede Schaltstufe ein eigenes Betätigungselement aufweist, insbesondere ein Betätigungselement (23) zum Erhöhen der Schaltstufe und ein Betätigungselement (24) zum Erniedrigen der Schaltstufe.

11. Steuerungsanordnung nach einem der vorhergehenden Ansprüche, bei der jede Steueruntereinheit (7) eine Topferkennung aufweist.

12. Steuerungsanordnung nach einem der vorhergehenden Ansprüche, bei der die Steuereinheit (5) derart ausgebildet ist, daß sie bei zu langer ununterbrochener Betätigung eines Betätigungselements (8) alle Verbraucher abschaltet.

13. Steuerungsanordnung nach einem der vorhergehenden Ansprüche, bei der die Steuereinheit (5) derart ausgebildet ist, daß sie bei gleichzeitiger Betätigung mehrerer Betätigungslemente (8) keine Änderung des Steuerzustands vornimmt.

14. Steuerungsanordnung nach einem der vorhergehenden Ansprüche, mit einer Redundanzüberprüfung aller wichtigen Steuerparameter.

15. Steuerungsanordnung nach einem der vorhergehenden Ansprüche, mit einem eine Verriegelung bewirkenden Betätigungselement, das im ausgeschalteten Zustand aller Verbraucher ein Einschalten unmöglich macht.
